# EUROPEAN PATENT SPECIFICATION

(11) **EP 4 307 256 B1**
(45) Date of publication and mention of the grant of the patent: **22.07.2026**
(21) Application number: 22898942.2
(22) Date of filing: 16.11.2022
(51) Int. Cl.: H04L 12/12, H04L 12/40, B60L 3/12, H04Q 9/00, G01R 19/165

(54) **VEHICLE DIAGNOSTIC DEVICE FOR ELECTRIC VEHICLE**
FAHRZEUGDIAGNOSEVORRICHTUNG FÜR EIN ELEKTROFAHRZEUG
DISPOSITIF DE DIAGNOSTIC DE VÉHICULE POUR VÉHICULE ÉLECTRIQUE

(30) Priority: 23.11.2021 KR 20210162803
(43) Date of publication of application: 17.01.2024
(73) Proprietor: LG Energy Solution, Ltd., Seoul 07335 (KR)
(72) Inventor: JANG, Man-Hoo, Daejeon 34122 (KR)
(74) Representative: Plasseraud IP
(86) International application number: PCT/KR2022/018129
(87) International publication number: WO 2023/096260

(56) References cited:
- CN-A- 113 126 586
- JP-A- 2015 199 444
- KR-A- 20190 012 674
- KR-A- 20190 051 477
- KR-A- 20200 119 729
- KR-B1- 101 553 396
- US-A1- 2012 257 655
- US-A1- 2020 267 018
- US-A1- 2021 224 079

## Description

### TECHNICAL FIELD

The present disclosure relates to a vehicle diagnostic device for an electric vehicle, and more particularly, to an electronic device that can be connected to a D-CAN channel in a vehicle network system of an electric vehicle, and collects diagnosis data from at least one of electronic devices connected to another CAN channel in the electric vehicle when connected to the D-CAN channel.

### BACKGROUND ART

Recently, with the widespread use of electric vehicles, different types of electronic devices in the electric vehicles have diverse and advanced functions.

A vehicle network system of an electric vehicle is designed to support good and efficient communication between electronic devices of the electric vehicle, and basically Controller Area Network (CAN) communication is applied. The CAN communication refers to a message-based standard communication protocol designed to allow a micro controller or devices to communicate each other without a host computer in not only electric vehicles but also industrial and medical equipment. Document US 2020/0267018 is related to CAN communications. Document CN113126586A is related to a wake-up diagnosis device that employs CAN bus wake-up and local wake-up.

The electronic devices in the electric vehicle may be categorized into a plurality of groups according to the use. Additionally, there is an additional electronic device that is detachably provided to the vehicle network system outside of the electric vehicle to diagnose the state of the electric vehicle. The vehicle network system provides a plurality of CAN communication channels (for example, P-CAN, B-CAN, C-CAN, D-CAN) and the electronic devices in the same group among the electronic devices inside and outside of the electric vehicle are connected in parallel through a specific communication channel among the plurality of CAN communication channels.

The vehicle network system outputs a wakeup pattern to at least one of the plurality of CAN communication channels according to the state of the electric vehicle. The electronic devices change from a sleep mode to a wakeup mode in response to the predetermined input wakeup pattern from the electric vehicle through the CAN communication channel to which the electronic devices are connected during the operation in the sleep mode.

In the electric vehicle, a relationship map is recorded between a plurality of states (for example, ignition On, ignition Off, charging) that the electric vehicle may experience and the CAN communication channels that will output the wakeup pattern in each state. For example, the 'ignition On' state may be set to output the wakeup pattern to all the CAN communication channels, and the 'ignition Off state may be set to output the wakeup pattern to only the B-CAN.

The electric vehicle includes a diagnostic communication port referred to as 'OBD-II' in a predetermined area inside the interior room, and the D-CAN channel, one of the plurality of CAN communication channels in the vehicle network system, is connected to the diagnostic communication port. The electronic device (for example, a diagnosis scanner) as a diagnostic device for the electric vehicle is detachably provided to the diagnostic communication port through its connector and transmits a diagnosis request to the vehicle network system when coupled to the diagnostic communication port and collects input diagnosis data from the vehicle network system in response to the diagnosis request.

However, while the vehicle network system does not output the wakeup pattern to the D-CAN channel since the electric vehicle is in the specific state (for example, charging), even though the electronic device is connected to the diagnostic communication port, the electronic device cannot wake up from the sleep mode and collect diagnosis data associated with the electric vehicle.

### DISCLOSURE

### Technical Problem

The present disclosure is designed to solve the above-described problem, and therefore the present disclosure is directed to providing an electronic device that detects bias voltage of a signal line of a D-CAN channel, generates a wakeup signal, and automatically wakes up from a sleep mode by the wakeup signal to collect diagnosis data from an electric vehicle even though a wakeup pattern is not input to the D-CAN channel since the electric vehicle is in a specific state (for example, charging).

These and other objectives and advantages of the present disclosure may be understood by the following description and will be apparent from an embodiment of the present disclosure. In addition, it will be readily understood that the objectives and advantages of the present disclosure may be realized by the means set forth in the appended claims and a combination thereof.

### Technical Solution

The present invention is defined in the appended independent claim 1 to which reference should be made. Advantageous features are set out in the appended dependent claims.

### Advantageous Effects

According to at least one of the embodiments of the present disclosure, it is possible to detect bias voltage of the signal line of the D-CAN channel, generate a wakeup signal, and automatically wake up from a sleep mode by the wakeup signal to collect diagnosis data from the electric vehicle even though a wakeup pattern is not input to the D-CAN channel since the electric vehicle is in a specific state (for example, charging).

The effects of the present disclosure are not limited to the above-mentioned effects, and these and other effects will be clearly understood by those skilled in the art from the appended claims.

### DESCRIPTION OF DRAWINGS

The accompanying drawings illustrate an exemplary embodiment of the present disclosure, and together with the following detailed description, serve to provide a further understanding of the technical aspect of the present disclosure, and thus the present disclosure should not be construed as being limited to the drawings.
FIG. 1 is a diagram exemplarily showing an electric vehicle related to the present disclosure and a vehicle diagnostic device detachably provided to the electric vehicle outside of the electric vehicle.
FIG. 2 is a diagram schematically showing the configuration of the vehicle diagnostic device shown in FIG. 1.
FIG. 3 is a timing chart referenced in describing the operation of a wakeup circuit of FIG. 2.

### BEST MODE

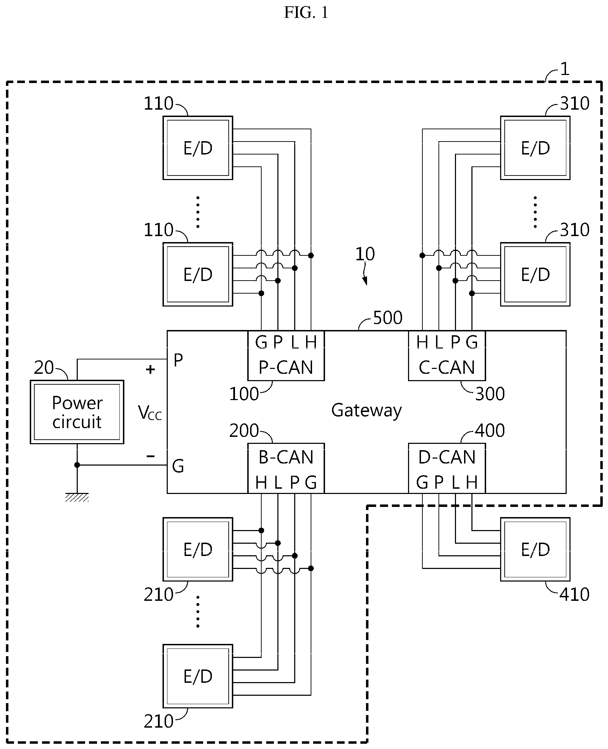

FIG. 1 is a diagram exemplarily showing an electric vehicle 1 related to the present disclosure and a vehicle diagnostic device 410 detachably provided to the electric vehicle 1 outside of the electric vehicle 1.

Referring to FIG. 1, the electric vehicle 1 includes a vehicle network system 10, electronic devices 110, 210, 310 and a power circuit 20.

The vehicle network system 10 includes a P(Powertrain)-CAN channel 100, a B(Body)-CAN channel 200, a C(Chassis)-CAN channel 300, a D(Diagnostic)-CAN channel 400 and a gateway 500.

Each of the electronic devices 110, 210, 310 is connected to one of the P-CAN channel 100, the B-CAN channel 200, the C-CAN channel 300 and the D-CAN channel 400. From the perspective of the vehicle network system 10, each of electronic devices 110, 210, 310, 410 may be referred to as a 'node'. Two or more electronic devices may be connected in parallel to each of the P-CAN channel 100, the B-CAN channel 200, the C-CAN channel 300 and the D-CAN channel 400.

The power circuit 20 is configured to supply a power source voltage V_{CC} required for the operation of the vehicle network system 10 and the electronic devices 110, 210, 310. For example, the power circuit 20 may include a battery (for example, a lead acid battery) and a voltage regulator to convert the output voltage of the battery to the power source voltage V_{CC} of a predetermined constant voltage value (for example, 12 [V]).

The P-CAN channel 100 is provided for the communication with the electronic devices 110 related to the driving function of the electric vehicle 1, for example, an engine, a steering wheel, an electric motor and an electronic pedal.

The B-CAN channel 200 is provided for the communication with the electronic devices 210 irrelevant to the driving function of the electric vehicle 1, for example, a smart key module, a light, an electronic door, a sunroof, a wiper, an airbag, an air conditioner and a power window.

The C-CAN channel 300 is provided for the communication with the electronic devices 310 responsible for the function related to the chassis of the electric vehicle 1, for example, a cluster and a Yaw Rate Sensor (YRS), and may support higher communication speed than the B-CAN.

The D-CAN channel 400 is used to transmit a diagnosis request from the vehicle diagnostic device 410 disposed outside of the electric vehicle 1 to at least one of the electronic devices 110, 210, 310 disposed inside of the electric vehicle 1, and transmit and receive diagnosis data output from the electronic devices 110, 210, 310 in response to the diagnosis request. Hereinafter, to distinguish the vehicle diagnostic device 410 from the electronic devices 110, 210, 310, the vehicle diagnostic device 410 is referred to as a 'vehicle diagnostic device'.

The gateway 500 is the crucial component of the vehicle network system 10, and takes responsibility for message exchange, communication path setting and communication speed control functions between the P-CAN channel 100, the B-CAN channel 200, the C-CAN channel 300 and the D-CAN channel 400. The gateway 500 relays the communication from any one of the P-CAN channel 100, the B-CAN channel 200, the C-CAN channel 300 or the D-CAN channel 400 to at least one of the other channels. For example, when the diagnosis request from the vehicle diagnostic device 410 is received by the gateway 500 through the D-CAN channel 400, the gateway 500 identifies the electronic devices 110, 210, 310 in the electric vehicle 1 associated with the received diagnosis request, and inputs the corresponding diagnosis request to the CAN channels 100, 200, 300 connected to the identified electronic devices 110, 210, 310. Then, the identified electronic devices 110, 210, 310 receive the diagnosis request through the CAN channels 100, 200, 300 to which the electronic devices 110, 210, 310 are connected, and returns the diagnosis data being inquired in the received diagnosis request to the CAN channels 100, 200, 300 to which the electronic devices 110, 210, 310 are connected. The returned diagnosis data is inputted to the vehicle diagnostic device 410 through the D-CAN channel 400 via the gateway 500. The diagnosis data indicates the state of at least one component identified by the diagnosis request among the plurality of components mounted in the electric vehicle 1. For example, the diagnosis request inquiring about a State Of Health (SOH) of a battery pack of the electric vehicle 1 is transmitted to a Battery Management System (BMS), one of the electronic devices 110, 310 connected to the P-CAN channel 100 or the C-CAN channel 300, through the gateway 500. In response to the diagnosis request, the BMS performs the calculation function of the SOH of the battery pack, and transmits a message indicating the calculated SOH as the diagnosis data to the gateway 500.

The gateway 500 is connected to each of the power circuit 20 and the ground (for example, the chassis) to provide the input power source voltage V_{CC} from the power circuit 20 to between a power pin P and a ground pin G of each of the P-CAN channel 100, the B-CAN channel 200, the C-CAN channel 300 and the D-CAN channel 400.

In FIG. 1, the symbols H, L, P and G refer to a first signal line, a second signal line, a ground line and a power line and pins connected to them. Each CAN channel is a bundle of the four electrical lines, i.e., the first signal line (CAN-H line, H), the second signal line (CAN-L line, L), the power line P and the ground line G. The first signal line H and the second signal line L are used for the communication of the vehicle diagnostic device 410, and a pair of the first signal line H and the second signal line L may be referred to as a 'CAN-bus'. The ground line feeds a ground voltage (the potential of the chassis) of the electric vehicle 1. The power line P is connected to the output terminal of the power circuit 20 to feed the power source voltage V_{CC}. The power source voltage V_{CC} is used to operate the electronic devices 110, 210, 310, 410. For reference, in the CAN communication, the first signal line H is typically represented as 'CAN-H', 'CAN-high' or 'CAN+', and the second signal line L is typically represented as 'CAN-L', 'CAN-low' or 'CAN-'.

In response to the electric vehicle 1 being in a first state (for example, ignition On), the gateway 500 may output the predetermined wakeup pattern through the first signal line H and the second signal line L of all the P-CAN channel 100, the B-CAN channel 200, the C-CAN channel 300 and the D-CAN channel 400. For example, the wakeup pattern may be based on ISO 11898-2.

In response to the electric vehicle 1 being in a second state (for example, ignition Off), the gateway 500 may stop the output of the predetermined wakeup pattern through the CAN-bus of all the P-CAN channel 100, the B-CAN channel 200, the C-CAN channel 300 and the D-CAN channel 400.

In response to the electric vehicle 1 being in a third state (for example, ignition preparation, charging), the gateway 500 stops the output of the predetermined wakeup pattern to the first signal line H and the second signal line L of at least one CAN channel among the P-CAN channel 100, the B-CAN channel 200 and the C-CAN channel 300, and instead, may output the bias voltage of the predetermined constant voltage value (for example, 2.5V) to at least one of the first signal line H or the second signal line L of the corresponding CAN channel. The ignition preparation state may be a state of preparation for the ignition On state of the electric vehicle 1 in response to the smart key module, one of the electronic devices 210 connected to the B-CAN channel 200, detecting the smart key approaching within a predetermined distance from the electric vehicle 1.

In response to the electric vehicle 1 being in the third state, the gateway 500 may output the bias voltage of the predetermined constant voltage value to at least one of the first signal line H or the second signal line L of the D-CAN channel 400.

During the output of the predetermined wakeup pattern to at least one of the P-CAN channel 100, the B-CAN channel 200 or the C-CAN channel 300, the gateway 500 may output the bias voltage of the predetermined constant voltage value to at least one of the first signal line H or the second signal line L of the D-CAN channel 400.

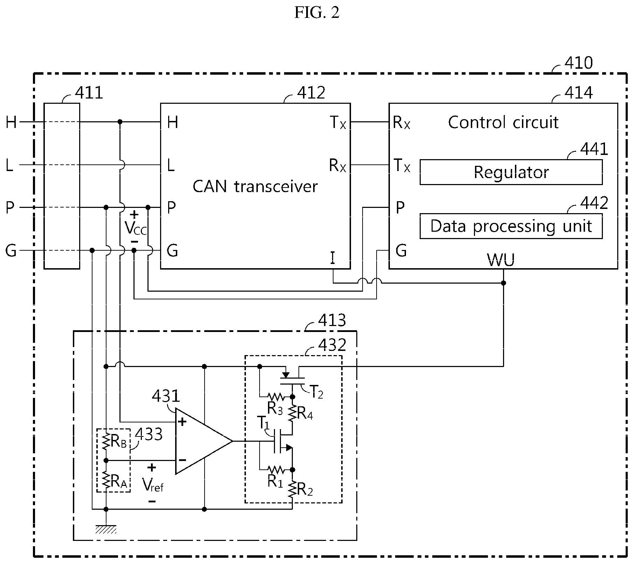

FIG. 2 is a diagram schematically showing the configuration of the vehicle diagnostic device 410 shown in FIG. 1.

Referring to FIG. 2, the vehicle diagnostic device 410 includes a connector 411, a CAN transceiver 412, a wakeup circuit 413 and a control circuit 414.

The connector 411 may be attached to or detached from the 4 pins (H, L, P, G) of the D-CAN channel 400 in the vehicle network system 10 of the electric vehicle 1. Each of the CAN transceiver 412, the wakeup circuit 413 and the control circuit 414 is connected to at least one of the 4 pins (H, L, P, G) through the connector 411.

The CAN transceiver 412 is connected to the first signal line H and the second signal line L through the connector 411 to output a first wakeup signal from the wakeup pin I in response to a change in voltage difference between the first signal line H and the second signal line L being matched to the predetermined wakeup pattern. The wakeup pin WU of the control circuit 414 is connected to the wakeup pin I of the CAN transceiver 412. The control circuit 414 changes from the sleep mode to the wakeup mode in response to the first wakeup signal being input to the wakeup pin WU in the sleep mode. After the wake up, the control circuit 414 may communicate with the electric vehicle 1 using the CAN transceiver 412. The signal output pin T_{X} of the control circuit 414 is connected to the signal input pin R_{X} of the CAN transceiver 412, and the signal input pin R_{X} of the control circuit 414 is connected to the signal output pin T_{X} of the CAN transceiver 412. The CAN transceiver 412 transmits the message received through the first signal line H and the second signal line L to the signal input pin R_{X} of the control circuit 414 through the signal output pin T_{X} of the CAN transceiver 412. The CAN transceiver 412 receives the message outputted from the signal output pin Tx of the control circuit 414 through the signal input pin R_{X} of the CAN transceiver 412, and transmits the received message to the gateway 500 through the first signal line H and the second signal line L.

The wakeup circuit 413 is configured to wake up the control circuit 414 independently of the function of the CAN transceiver 412 to wake up the control circuit 414. Specifically, the wakeup circuit 413 is configured to output a second wakeup signal in response to the voltage of the first signal line H or the second signal line L of the D-CAN channel 400 being larger than the reference voltage V_{ref} while the CAN transceiver 412 cannot output the first wakeup signal to the control circuit 414 since the wakeup pattern is not input through the D-CAN channel 400. The output pin of the wakeup circuit 413 is connected to the wakeup pin WU of the control circuit 414. The control circuit 414 changes from the sleep mode to the wakeup mode in response to the second wakeup signal input to the wakeup pin WU in the sleep mode.

Each of the first wakeup signal and the second wakeup signal may refer to a high level voltage that is equal to or larger than a predetermined voltage value.

The wakeup circuit 413 includes a comparator 431 and a signal transmission circuit 432, and may further include a voltage divider 433.

The comparator 431 include an input pin (+), an input pin (-) and an output pin. The voltage of the first signal line H is input to the input pin (+) through the connector 411. FIG. 2 shows the first signal line H connected to the input pin (+). The reference voltage V_{ref} that is equal to or larger than the predetermined voltage value (for example, 2V) is input to the input pin (-). The reference voltage V_{ref} is less than the bias voltage output to the first signal line H. In response to the input voltage of the input pin (+) being larger than the input voltage V_{ref} of the input pin (-), the comparator 431 outputs the high level voltage of the predetermined voltage value from the output pin. The comparator 431 may operate using the power source voltage V_{CC}. The high level voltage output from the output pin of the comparator 431 may be equal to the power source voltage V_{CC}. The comparator 431 outputs a low level voltage of a predetermined voltage value (for example, 0 [V]) from the output pin in response to the input voltage of the input pin (+) being smaller than the input voltage of the input pin (-). The low level voltage output from the output pin of the comparator 431 may be equal to the ground voltage.

FIG. 2 shows the signal transmission circuit 432 including a first resistor R₁, a second resistor R₂, a first transistor T₁, a third resistor R₃, a fourth resistor R₄, and a second transistor T₂.

The gate of the first transistor T₁ is connected to the output pin of the comparator 431. The first resistor R₁ is connected between the gate of the first transistor T₁ and the source of the first transistor T₁. The second resistor R₂ is connected between the source of the first transistor T₁ and the ground. The source of the second transistor T₂ is connected to the power line P. The drain of the second transistor T₂ is connected to the wakeup pin WU of the control circuit 414. The third resistor R₃ is connected between the gate of the second transistor T₂ and the source of the second transistor T₂. The fourth resistor R₄ is connected between the gate of the second transistor T₂ and the drain of the first transistor T₁. The first transistor T₁ may be an N-channel MOSFET. The second transistor T₂ may be a P-channel MOSFET. During the output of the high level voltage from the output pin of the comparator 431, the first transistor T₁ is in an on state. While the first transistor T₁ is in the on state, an electric current flows through the third resistor R₃, the fourth resistor R₄, the first transistor T₁ and the second resistor R₂, and accordingly, voltage across the third resistor R₃ is inputted as gate-source voltage of the second transistor T₂, and the second transistor T₂ is in the on state. While the second transistor T₂ is in the on state, the power source voltage V_{CC} is inputted to the wakeup pin WU of the control circuit 414 as the second wakeup signal.

The voltage divider 433 includes a resistor R_{A} and a resistor R_{B}. The power source voltage V_{CC} is split by a resistance ratio between the resistor R_{A} and the resistor R_{B} and the reference voltage V_{ref} is inputted to the input pin (-). That is, V_{ref} = V_{CC} × R_{A}/(R_{A} + R_{B}). Although FIG. 2 shows the reference voltage V_{ref} provided from the power source voltage V_{CC}, the output voltage of an accumulator such as a coin cell may be used for the reference voltage V_{ref}.

The control circuit 414 may be configured to change from the sleep mode to the wakeup mode in response to the input of the first wakeup signal or the second wakeup signal maintaining for a predetermined time in the sleep mode.

The control circuit 414 includes a voltage regulator 441 and a data processing unit 442. The voltage regulator 441 may be configured to step-down the power source voltage V_{CC} input to the power pin P of the control circuit 414 to a voltage (for example, 5 [V]) in response to the first wakeup signal or the second wakeup signal being input to the wakeup pin WU. The data processing unit 442 is configured to change from the sleep mode to the wakeup mode when activated (powered) upon receiving the voltage generated from the power source voltage V_{CC} by the voltage regulator 441. The data processing unit 442 may be implemented in hardware using at least one of application specific integrated circuits (ASICs), digital signal processors (DSPs), digital signal processing devices (DSPDs), programmable logic devices (PLDs), field programmable gate arrays (FPGAs), microprocessors or electrical units for performing other functions.

After the control circuit 414 changes from the sleep mode to the wakeup mode by the first wakeup signal, in response to the first wakeup signal being not inputted for a predetermined time, the control circuit 414 may change from the wakeup mode to the sleep mode. Of course, even in a situation in which the first wakeup signal is not inputted for more than the predetermined time, when the second wakeup signal is being inputted, the control circuit 414 may be kept in the wakeup state.

After the control circuit 414 changes from the sleep mode to the wakeup mode by the second wakeup signal, in response to the second wakeup signal being not inputted for the predetermined time, the control circuit 414 may change from the wakeup mode to the sleep mode. Of course, even in a situation in which the second wakeup signal is not inputted for more than the predetermined time, when the first wakeup signal is being inputted, the control circuit 414 may be kept in the wakeup state.

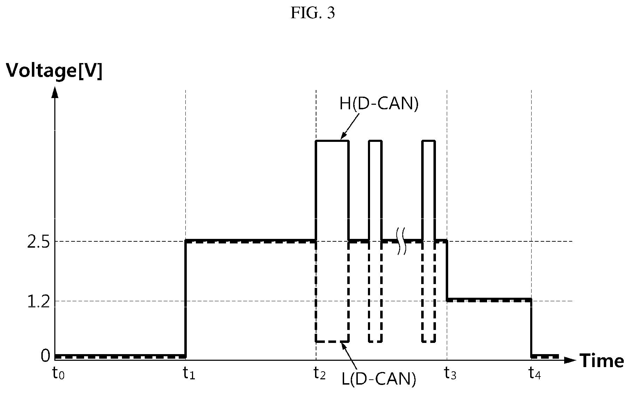

FIG. 3 is a timing chart referenced in describing the operation of the wakeup circuit 413 of FIG. 2.

In the CAN communication, a state in which voltage of each of the first signal line H and the second signal line L is equal to the bias voltage may be referred to as a 'recessive state'. Meanwhile, a state in which the voltage (for example, 3.5 to 5V) of the first signal line H is higher than the bias voltage and the voltage (for example, 0 to 1.5V) of the second signal line L is lower than the bias voltage is referred to as a 'dominant state'. In the dominant state, a voltage difference between the first signal line H and the second signal line L may be about 2 to 5V. The communication between the electric vehicle 1 and the vehicle diagnostic device 410 using the D-CAN channel 400 is performed by time-series changes of the recessive state and the dominant state.

Referring to FIGS. 1 to 3, as shown, when the electric vehicle 1 is in the second state for a period of time of from time t₀ to time t₁, not only the D-CAN channel 400 but also the P-CAN channel 100, the B-CAN channel 200 and the C-CAN channel 300 are inactivated, that is to say, the voltage of the first signal line H and the second signal line L is 0 V.

When the electric vehicle 1 changes from the second state to the third state at the time t₁, the state is shifted to the recessive state of 2.5 V in which the first signal line H and the second signal line L of the D-CAN channel 400 is larger than the reference voltage V_{ref}, and is maintained until time t₂. When the time t₂ is the time after the lapse of a predefined time from the time t₁ for wakeup, the control circuit 414 changes from the sleep mode to the wakeup mode at the time t₂.

The control circuit 414 may collect the diagnosis data via communication with the electric vehicle 1 using the CAN transceiver 412 by the operation in the wakeup mode for a period of time from time t₂ to time t₃.

From the time t₃ when the state is shifted to the recessive state of 1.2 V in which the first signal line H and the second signal line L of the D-CAN channel 400 is smaller than the reference voltage V_{ref}, the wakeup circuit 413 stops the output of the second wakeup signal. The recessive state of 1.2 V is kept for a few seconds to a few minutes from the time when the electric vehicle 1 changes from the third state to the second state, and is shifted to the recessive state of 0V at time t₄. The recessive state of 1.2 V relies on the voltage difference between the electric vehicle 1 and the CAN bus (H, L) of the D-CAN channel 400. The control circuit 414 changes from the wakeup mode to the sleep mode again in response to the recessive state in which the first signal line H and the second signal line L is smaller than the reference voltage V_{ref} being maintained for the predetermined time or more during the operation in the wakeup mode.

### [Description of Reference Numerals]

| | | | |
|---|---|---|---|
| 1: | Electric vehicle | | |
| 10: | Vehicle network system | 20: | Power circuit |
| 100: | P-CAN channel | 200: | B-CAN channel |
| 300: | C-CAN channel | 400: | D-DAN channel |
| 500: | Gateway | | |
| 110, 210, 310, 410: | Electronic device | | |
| 411: | Connector | 412: | CAN transceiver |
| 413: | Wakeup circuit | 414: | Control circuit |

## Claims

1. A vehicle diagnostic device for an electric vehicle (1) comprising:
a connector (411) configured to be attached to or detach from a Diagnostic Controller Area Network, D-CAN, channel (400) in a vehicle network system (10) of the electric vehicle (1);
a CAN transceiver (412) connected to a first signal line and a second signal line of the D-CAN channel (400) through the connector;
a wakeup circuit (413) connected to the first signal line (H) or the second signal line (L) through the connector (411); and
a control circuit (414) configured to:
change from a sleep mode to a wakeup mode in response to an input of a first wakeup signal outputted by the CAN transceiver (412) or a second wakeup signal outputted by the wakeup circuit (413) in the sleep mode, and
collect diagnosis data from the vehicle network system through the CAN transceiver (412) in the wakeup mode;
wherein the CAN transceiver (412) is configured to output the first wakeup signal to the control circuit (414) in response to an input of a wakeup pattern from the D-CAN channel (400), and
wherein the wakeup circuit (413) is configured to output the second wakeup signal to the control circuit (414) in response to an input voltage from the first signal line (H) or the second signal line (L) being larger than a reference voltage, while the CAN transceiver (412) cannot output the first wakeup signal;
wherein the wakeup circuit (413) includes:
a comparator (431) configured to output a high level voltage in response to the input voltage being larger than the reference voltage; and
a signal transmission circuit (432) configured to output a power source voltage from a power circuit provided in the electric vehicle (1) as the second wakeup signal to the control circuit (414) in response to the high level voltage.

2. The vehicle diagnostic device according to claim 1, wherein the wakeup circuit (413) includes a voltage divider (433) to split a first power source voltage from a power circuit provided in the electric vehicle (1) to generate the reference voltage.

3. The vehicle diagnostic device according to claim 1, wherein the signal transmission circuit (432) includes:
a first transistor (T₁) including a gate connected to an output pin of the comparator, a source and a drain;
a first resistor (R₁) connected between the gate of the first transistor (T₁) and the source of the first transistor (T₁),
a second resistor (R₂) connected between the source of the first transistor (T₁) and a ground;
a second transistor (T₂) including a gate, a source connected to the power circuit and a drain connected to the control circuit;
a third resistor (R₃) connected between the gate of the second transistor (T₂) and the source of the second transistor (T₂); and
a fourth resistor (R₁) connected between the gate of the second transistor (T₂) and the drain of the first transistor (T₁).

4. The vehicle diagnostic device according to claim 3, wherein the first transistor (T₁) is an N-channel MOSFET, and
wherein the second transistor (T₂) is a P-channel MOSFET.

5. The vehicle diagnostic device according to claim 1, wherein the control circuit (414) includes:
a voltage regulator (441) configured to step-down a power source voltage from a power circuit in the electric vehicle to another voltage in response to the input of the first wakeup signal or the second wakeup signal; and
a data processing unit (442) configured to operate in the wakeup mode in response to the input of the power source voltage from the voltage regulator (441) in the sleep mode.

6. The vehicle diagnostic device according to claim 1, wherein the control circuit (414) is configured to change from the sleep mode to the wakeup mode in response to the input of the first wakeup signal or the second wakeup signal maintaining for a predetermined time in the sleep mode.

7. The vehicle diagnostic device according to claim 1, wherein the control circuit (414) is configured to change from the wakeup mode to the sleep mode in response to the second wakeup signal being not inputted for a predetermined time after the change from the sleep mode to the wakeup mode by the second wakeup signal.

## Patentansprüche

1. Fahrzeugdiagnosevorrichtung für ein Elektrofahrzeug (1), umfassend:
einen Verbinder (411), der konfiguriert ist, um an einen Diagnose-Controller-Area-Network-Kanal, D-CAN-Kanal, (400) in einem Fahrzeugnetzwerksystem (10) des Elektrofahrzeugs (1) angeschlossen oder von diesem getrennt zu werden;
einen CAN-Transceiver (412), der über den Verbinder mit einer ersten Signalleitung und einer zweiten Signalleitung des D-CAN-Kanals (400) verbunden ist;
eine Weckschaltung (413), die über den Verbinder (411) mit der ersten Signalleitung (H) oder der zweiten Signalleitung (L) verbunden ist; und
eine Steuerschaltung (414), die konfiguriert ist, um:
von einem Schlafmodus in einen Weckmodus zu wechseln, als Reaktion auf eine Eingabe eines ersten Wecksignals, das vom CAN-Transceiver (412) ausgegeben wird, oder eines zweiten Wecksignals, das von der Weckschaltung (413) im Schlafmodus ausgegeben wird, und
Diagnosedaten vom Fahrzeugnetzwerksystem über den CAN-Transceiver (412) im Weckmodus zu sammeln;
wobei der CAN-Transceiver (412) konfiguriert ist, um das erste Wecksignal an die Steuerschaltung (414) als Reaktion auf eine Eingabe eines Weckmusters vom D-CAN-Kanal (400) auszugeben, und
wobei die Weckschaltung (413) konfiguriert ist, um das zweite Wecksignal an die Steuerschaltung (414) als Reaktion darauf auszugeben, dass eine Eingangsspannung von der ersten Signalleitung (H) oder der zweiten Signalleitung (L) größer als eine Referenzspannung ist, während der CAN-Transceiver (412) das erste Wecksignal nicht ausgeben kann;
wobei die Weckschaltung (413) Folgendes beinhaltet:
einen Komparator (431), der konfiguriert ist, um eine Hochpegelspannung als Reaktion darauf auszugeben, dass die Eingangsspannung größer als die Referenzspannung ist; und
eine Signalübertragungsschaltung (432), die konfiguriert ist, um eine Stromquellenspannung von einem im Elektrofahrzeug (1) vorgesehenen Stromkreis als zweites Wecksignal an die Steuerschaltung (414) als Reaktion auf die Hochpegelspannung auszugeben.

2. Die Fahrzeugdiagnosevorrichtung nach Anspruch 1, wobei die Weckschaltung (413) einen Spannungsteiler (433) enthält, um eine erste Stromquellenspannung von einem im Elektrofahrzeug (1) vorgesehenen Stromkreis zu teilen, um die Referenzspannung zu erzeugen.

3. Die Fahrzeugdiagnosevorrichtung nach Anspruch 1, wobei die Signalübertragungsschaltung (432) Folgendes beinhaltet:
einen ersten Transistor (T₁), der ein Gate, das mit einem Ausgangspin des Komparators verbunden ist, eine Source und einen Drain aufweist;
einen ersten Widerstand (R₁), der zwischen dem Gate des ersten Transistors (T₁) und der Source des ersten Transistors (T₁) verbunden ist;
einen zweiten Widerstand (R₂), der zwischen der Source des ersten Transistors (T₁) und einer Masse verbunden ist;
einen zweiten Transistor (T₂), der ein Gate, eine Source, die mit dem Stromkreis verbunden ist, und einen Drain, der mit der Steuerschaltung verbunden ist, aufweist;
einen dritten Widerstand (R₃), der zwischen dem Gate des zweiten Transistors (T₂) und der Source des zweiten Transistors (T₂) verbunden ist; und
einen vierten Widerstand (R₁), der zwischen dem Gate des zweiten Transistors (T₂) und dem Drain des ersten Transistors (T₁) verbunden ist.

4. Die Fahrzeugdiagnosevorrichtung nach Anspruch 3, wobei der erste Transistor (T₁) ein N-Kanal-MOSFET ist, und
wobei der zweite Transistor (T₂) ein P-Kanal-MOSFET ist.

5. Die Fahrzeugdiagnosevorrichtung nach Anspruch 1, wobei die Steuerschaltung (414) Folgendes beinhaltet:
einen Spannungsregler (441), der konfiguriert ist, um eine Stromquellenspannung von einem Stromkreis im Elektrofahrzeug auf eine andere Spannung als Reaktion auf die Eingabe des ersten Wecksignals oder des zweiten Wecksignals herabzusetzen; und
eine Datenverarbeitungseinheit (442), die konfiguriert ist, um im Weckmodus als Reaktion auf die Eingabe der Stromquellenspannung vom Spannungsregler (441) im Schlafmodus zu arbeiten.

6. Die Fahrzeugdiagnosevorrichtung nach Anspruch 1, wobei die Steuerschaltung (414) konfiguriert ist, um vom Schlafmodus in den Weckmodus zu wechseln, als Reaktion darauf, dass die Eingabe des ersten Wecksignals oder des zweiten Wecksignals für eine vorbestimmte Zeit im Schlafmodus beibehalten wird.

7. Die Fahrzeugdiagnosevorrichtung nach Anspruch 1, wobei die Steuerschaltung (414) konfiguriert ist, um vom Weckmodus in den Schlafmodus zu wechseln, als Reaktion darauf, dass das zweite Wecksignal für eine vorbestimmte Zeit nach dem Wechsel vom Schlafmodus in den Weckmodus durch das zweite Wecksignal nicht eingegeben wird.

## Revendications

1. Dispositif de diagnostic de véhicule pour un véhicule électrique (1) comprenant :
un connecteur (411) configuré pour être fixé à ou détaché d'un canal de réseau de commande de diagnostic, D-CAN, (400) dans un système de réseau de véhicule (10) du véhicule électrique (1) ;
un émetteur-récepteur CAN (412) connecté à une première ligne de signal et à une seconde ligne de signal du canal D-CAN (400) par l'intermédiaire du connecteur;
un circuit de réveil (413) connecté à la première ligne de signal (H) ou à la seconde ligne de signal (L) par l'intermédiaire du connecteur (411) ; et
un circuit de commande (414) configuré pour :
passer d'un mode veille à un mode réveil en réponse à une entrée d'un premier signal de réveil délivré par l'émetteur-récepteur CAN (412) ou d'un second signal de réveil délivré par le circuit de réveil (413) en mode veille, et
collecter des données de diagnostic à partir du système de réseau de véhicule par l'intermédiaire de l'émetteur-récepteur CAN (412) en mode réveil;
dans lequel l'émetteur-récepteur CAN (412) est configuré pour délivrer le premier signal de réveil au circuit de commande (414) en réponse à une entrée d'un motif de réveil provenant du canal D-CAN (400), et
dans lequel le circuit de réveil (413) est configuré pour délivrer le second signal de réveil au circuit de commande (414) en réponse au fait qu'une tension d'entrée provenant de la première ligne de signal (H) ou de la seconde ligne de signal (L) est supérieure à une tension de référence, tandis que l'émetteur-récepteur CAN (412) ne peut pas délivrer le premier signal de réveil ;
dans lequel le circuit de réveil (413) inclut :
un comparateur (431) configuré pour délivrer une tension de niveau haut en réponse au fait que la tension d'entrée est supérieure à la tension de référence ; et
un circuit de transmission de signal (432) configuré pour délivrer une tension de source d'alimentation provenant d'un circuit d'alimentation prévu dans le véhicule électrique (1) en tant que second signal de réveil au circuit de commande (414) en réponse à la tension de niveau haut.

2. Le dispositif de diagnostic de véhicule selon la revendication 1, dans lequel le circuit de réveil (413) inclut un diviseur de tension (433) pour diviser une première tension de source d'alimentation provenant d'un circuit d'alimentation prévu dans le véhicule électrique (1) pour générer la tension de référence.

3. Le dispositif de diagnostic de véhicule selon la revendication 1, dans lequel le circuit de transmission de signal (432) inclut :
un premier transistor (T₁) incluant une grille connectée à une broche de sortie du comparateur, une source et un drain ;
une première résistance (R₁) connectée entre la grille du premier transistor (T₁) et la source du premier transistor (T₁) ;
une deuxième résistance (R₂) connectée entre la source du premier transistor (T₁) et une masse ;
un second transistor (T₂) incluant une grille, une source connectée au circuit d'alimentation et un drain connecté au circuit de commande ;
une troisième résistance (R₃) connectée entre la grille du second transistor (T₂) et la source du second transistor (T₂) ; et
une quatrième résistance (R₁) connectée entre la grille du second transistor (T₂) et le drain du premier transistor (T₁).

4. Le dispositif de diagnostic de véhicule selon la revendication 3, dans lequel le premier transistor (T₁) est un MOSFET à canal N, et
dans lequel le second transistor (T₂) est un MOSFET à canal P.

5. Le dispositif de diagnostic de véhicule selon la revendication 1, dans lequel le circuit de commande (414) inclut :
un régulateur de tension (441) configuré pour abaisser une tension de source d'alimentation provenant d'un circuit d'alimentation dans le véhicule électrique à une autre tension en réponse à l'entrée du premier signal de réveil ou du second signal de réveil ; et
une unité de traitement de données (442) configurée pour fonctionner en mode réveil en réponse à l'entrée de la tension de source d'alimentation provenant du régulateur de tension (441) en mode veille.

6. Le dispositif de diagnostic de véhicule selon la revendication 1, dans lequel le circuit de commande (414) est configuré pour passer du mode veille au mode réveil en réponse au fait que l'entrée du premier signal de réveil ou du second signal de réveil se maintient pendant un temps prédéterminé en mode veille.

7. Le dispositif de diagnostic de véhicule selon la revendication 1, dans lequel le circuit de commande (414) est configuré pour passer du mode réveil au mode veille en réponse au fait que le second signal de réveil n'est pas entré pendant un temps prédéterminé après le passage du mode veille au mode réveil par le second signal de réveil.
